Europäisches Patentamt

European Patent Office

Office européen des brevets

(19)

(11) EP 1 152 531 A2

(12) **EUROPEAN PATENT APPLICATION**

(43) Date of publication:
07.11.2001 Bulletin 2001/45

(51) Int Cl.⁷: $H03K\ 17/687$

(21) Application number: 01109622.9

(22) Date of filing: 18.04.2001

(84) Designated Contracting States:
**AT BE CH CY DE DK ES FI FR GB GR IE IT LI LU MC NL PT SE TR**
Designated Extension States:
**AL LT LV MK RO SI**

(30) Priority: **28.04.2000 JP 2000130806**

(71) Applicant: **Denso Corporation
Kariya-city, Aichi-pref., 448-8661 (JP)**

(72) Inventors:
• **Hattori, Hiroshi, Denso Corporation
Kariya-city, Aichi-pref., 448-8661 (JP)**
• **Kabune, Hideki, Denso Corporation
Kariya-city, Aichi-pref., 448-8661 (JP)**

(74) Representative:
**Winter, Brandl, Fürniss, Hübner, Röss, Kaiser,
Polte Partnerschaft
Patent- und Rechtsanwaltskanzlei
Alois-Steinecker-Strasse 22
85354 Freising (DE)**

(54) **Load drive apparatus**

(57)   A load drive apparatus is comprised of a plurality of intelligent power devices (IPD A to C) connected in parallel and a plurality of control units (155). Each IPD comprises power MOS transistors (201a to 201c) for on/off control thereof. One voltage supply line (156) and one ground line (157) are used in common for each of the power MOS transistors and for each of the control units. A capacitor (160) and a resistor (161) are connected in series between a power source terminal (153) and a ground terminal (154) in order to control LC oscillation with an inductance element (163) and the capacitor (160).

**FIG. 3**

EP 1 152 531 A2

**Description**

The present invention relates to a load drive apparatus to be used for driving an electric load such as a motor, a solenoid or the like.

In recent years, with rapid progress in the automatic control of vehicle, semiconductor switching devices are employed for attaining such electric load control.

However, with increase of loads, a self-protection circuit functions erroneously with the influence of a high voltage surge noise generated due to the inductance of an electric power source wire when a large current load turns on and off.

The present invention therefore has an object to overcome the above drawbacks by reducing terminals of a load drive apparatus and the number of wires connected to such terminals.

According to the present invention, a load drive apparatus is constructed to switch a current supplied from a power source to a load by a switching circuit, which has a switching device and a control unit (155) for controlling a switching operation of the switching device. A power source terminal is connected to a power source side of the power source, and a ground terminal is connected to a ground side of the power source. A voltage supply line is connected to the power source terminal to supply a voltage in common to the switching device and the control unit, and a ground line is provided in common to connect the switching device and the control unit to the ground terminal. The switching circuit may be provided in the plural number and connected in parallel with each other.

Preferably a first capacitor is connected between the power source terminal and the ground terminal, and a first resistor is connected in series with the first capacitor. An input terminal is provided so that an input signal is inputted from an external side and the switching means controls ON and OFF conditions of the switching device based on the input signal applied to the input terminal.

The above and other objects, features and advantages of the present invention will become more apparent from the following detailed description made with reference to the accompanying drawings. In the drawings:

Fig. 1 is a schematic diagram illustrating an ABS control system controlled by an ABS control ECU according to a first embodiment of the present invention;
Fig. 2 is a block diagram illustrating the ECU shown in Fig. 1;
Fig. 3 is a circuit diagram illustrating a semiconductor relay shown in Fig. 2;
Fig. 4 is a circuit diagram illustrating each IPD shown in Fig. 3;
Fig. 5 is a waveform diagram illustrating output waveforms of each portion of the semiconductor relay when the voltage supply is stopped;
Fig. 6A is a circuit diagram illustrating a RS flip-flop shown in Fig. 4;
Fig.6B is a waveform diagram illustrating operation of the RS flip-flop 213;
Fig. 7 is a timing diagram illustrating a relationship between a threshold level and a voltage of a power source supply line for a shorting in a load;
Fig. 8 is a timing diagram illustrating voltage waveforms of each portion of IPD for the input voltage from a relay drive unit;
Fig. 9 is a timing diagram illustrating the voltage waveforms of each portion of IPD for the input voltage from the relay drive unit in a second embodiment of the present invention;
Fig. 10 is a circuit diagram illustrating the IPD in a third embodiment of the present invention;
Fig. 11 is a circuit diagram illustrating the IPD in a fourth embodiment of the present invention;
Fig. 12 is a timing diagram illustrating voltage waveforms of each portion of the IPD for the input voltage from the relay drive unit;
Fig. 13 is a circuit diagram illustrating the IPD in a fifth embodiment of the present invention;
Fig. 14 is a timing diagram illustrating voltage waveforms of each portion of the IPD for the input voltage from the relay drive unit; and
Fig. 15 is a timing diagram illustrating voltage waveforms of each portion of the IPD for the input voltage from the relay drive unit.

The present invention will be described in further detail with reference to various embodiments, which are directed to an electronic control unit (ECU) for an anti-lock brake system (ABS) control.

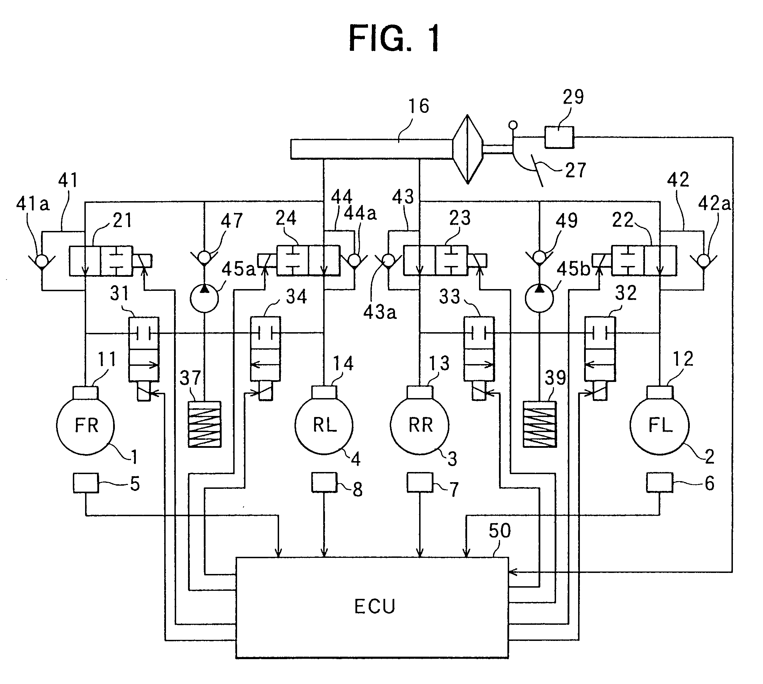

Referring first to Fig. 1 showing an ABS control system, a front-right (FR) wheel 1, a front-left (FL) wheel 2, a rear-right (RR) wheel 4 and a rear-left (RL) wheel 4 are provided with an electromagnetic pickup type, a magneto-resistive effect device (MRE) type or a Hall device type wheel speed sensors 5 to 8, respectively. These wheel speed sensors 5 to 8 generate respective pulse signals depending on rotation of the wheels 1 to 4.

Moreover, the wheels 1 to 4 are respectively provided with wheel cylinders 11 to 14. When a master cylinder 16 generates a brake fluid pressure depending on the driver's stepping-on amount of a brake pedal 27, this brake fluid pressure is transferred to the wheel cylinders 11 to 14 via dual-position valves (pressure increase control valves) 21 to 24 and through respective fluid pressure piping. The stepping-on condition of the brake pedal 27 is detected by a stop switch 29.

Moreover, the wheel cylinders 11, 14 are connected with a reservoir 37 via dual-position valves (pressure decrease control valves) 31, 34, respectively. The wheel cylinders 12, 13 are connected with a reservoir 39 via dual-position valves (pressure decrease control valves) 32, 33, respectively.

The dual-position valves 21 to 24 and 31 to 34 are each comprised of a solenoid drive type dual-position valve including a communication position and a shut-off position. These communication position and shut-off position can be switched by supplying electric power to the solenoid.

On the other hand, the upstream and downstream of the dual-position valves 21 to 24 are connected with bypass piping 41 to 44, respectively. These bypass piping 41 to 44 are provided with non-return valves 41a to 44a, respectively. Only the fluid pressure toward the master cylinder 16 from the wheel cylinders 11 to 14 flows through the bypass piping 41 to 44.

The reservoirs 37, 39 are connected with a fluid pressure piping via pumps 45a, 45b driven by a motor not illustrated and non-return valves 47, 49, respectively. Only the fluid pressure toward the master cylinder 16 from the reservoirs 37, 39 is allowed to flow.

Detection signals of the wheel speed sensors 5 to 8 and stop switch 29 are inputted to an ECU 50 for ABS control. The ABS control ECU 50 generates, based on the above detection signals, control signals for the dual-position valves 21 to 24 and 31 to 34 and motor control signals to drive the pumps 45a, 45b. On the basis of these control signals, the dual-position valves 21 to 24 and 31 to 34 and motor are controlled for the purpose of ABS control or the like.

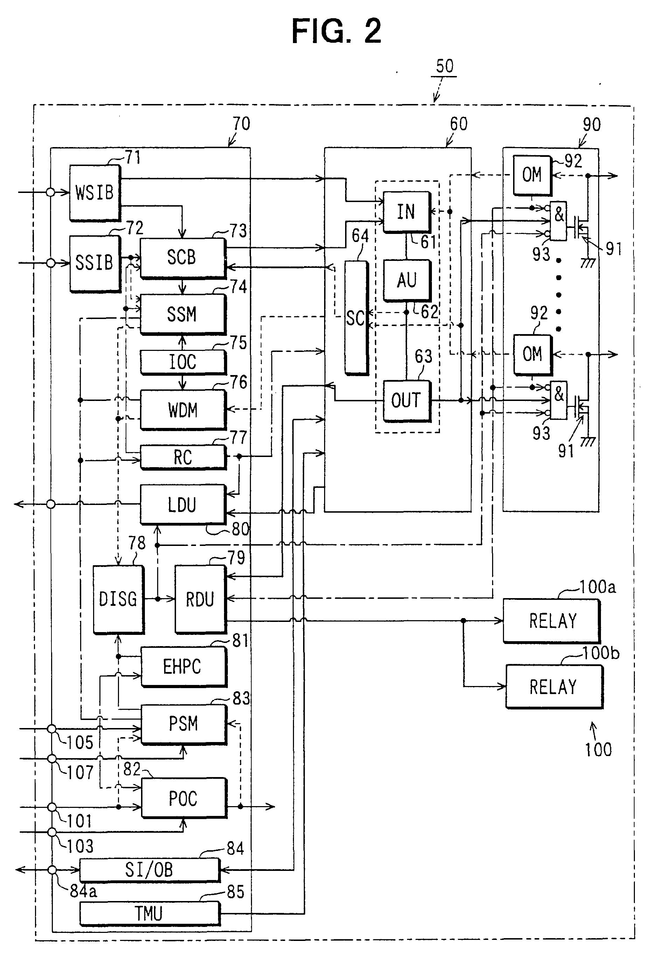

Fig. 2 illustrates a block diagram illustrating the internal structure of the ABS control ECU 50. As illustrated in this figure, the ABS control ECU 50 has a plurality of chips including a microcomputer 60, a peripheral IC 70, a solenoid driver 90 and a semiconductor relay 100 or the like.

Details of each structural device of the ABS control ECU 50 will then be described. Each arrow mark in a solid line in Fig. 2 indicates a control system line, each arrow mark in a broken line indicates a monitor system line, and each arrow mark in a chain line indicates an inhibit/shut-off system line. The control system line means that a device at the front end of the arrow mark is controlled based on a signal from a device at the rear end of the arrow mark. Moreover, the monitor system line means that a device at the front end of the arrow mark monitors whether a specified device fails or not based on a signal from a device at the rear end of the arrow mark. Moreover, the inhibit/shut-off system line means that a device at the front end of the arrow mark inhibits or shuts off a drive of a specified device based on an inhibit/shut-off signal from a device at the rear end of the arrow mark.

First, the microcomputer 60 comprises an input unit 61, an arithmetic unit 62, an output unit 63. When various information pieces such as the wheel speed signals are inputted to the input unit 61, the arithmetic unit 62 performs various arithmetic operations used for ABS control based on such various information inputs. The output unit 63 generates ABS control signals, that is, solenoid drive signals and motor drive signals based on the arithmetic operation. Moreover, the microcomputer 60 is also provided with a serial communication unit 64. When various signals produced in the arithmetic operation of the arithmetic unit 62 (for example, ABS control signal indicating the ABS control condition) are inputted, these various signals are converted to a serial signal and then sent to the peripheral IC 70 as the serial signal.

Next, the peripheral IC 70 comprises a wheel speed input buffer 71, a switch (SW) signal input buffer 72, a serial communication buffer 73, a serial communication monitor unit 74, an internal oscillator circuit 75, a watch-dog (WD) monitor unit 76, a reset control unit 77, a drive inhibit signal generating unit 78, a relay drive unit 79, a lamp drive circuit 80, an excessive-heating protection circuit 81, a power supply monitor unit 82, a power supply output circuit 83, a signal input/output buffer 84 and a temperature monitor unit 85. Each device circuit or unit is integrated into one chip to form the peripheral IC 70.

The wheel speed input buffer 71 performs waveform shaping to correct the detection signals transmitted from the wheel speed sensors 5 to 8 of Fig. 1 into a rectangular shape. The wheel speed signal shaped in the waveform by this wheel speed input buffer 71 is then inputted to the microcomputer 60 for various arithmetic operations of wheel speeds and estimated body speed used for ABS control. Moreover, the wheel speed input buffer 71 also detects a breakage of wire connecting the wheel speed sensors 5 to 8 and the ABS control ECU 50. This buffer 71 transmits a wire breakage signal indicating the breakage of wire to the serial communication buffer 73 when the wire breakage is detected.

The SW signal input buffer 72 monitors ON/OFF signal of the stop switch 29 and a signal indicating that the power is fed or not to the solenoids of the dual-position valves 21 to 24, 31 to 34 (for example, a voltage value applied on the solenoid) indicated in Fig. 1. Thereby, the ON/OFF signal indicating whether the brake pedal 27 is stepped on or not and the ON/OFF signal indicating whether the electric power is supplied to the solenoid or not can be outputted.

The serial communication buffer 73 converts a wire breakage signal from the wheel speed input buffer 71 and the ON/OFF signal from the SW signal input buffer 72 to the serial signal, and then transmits the serial signal to the microcomputer 60. A serial signal from the microcomputer 60 is then transmitted to this serial communication buffer 73.

The serial signal monitor unit 74 monitors the microcomputer 60 based on the serial signal from the serial communication buffer 73. More specifically, the serial communication buffer 73 receives the result of arithmetic operation from the microcomputer 60 based on the signals from the wheel speed input buffer 71 and SW signal input buffer 72 to monitor whether this signal is normal or not. For example, when the signal indicating the ABS control condition is transmitted from the serial control unit 64 in spite that the OFF signal indicating that the stop switch 29 is not stepped on is transmitted from the SW signal input buffer 72, it is determined that the serial signal from the microcomputer 60 is not normal. When the serial signal from the microcomputer 60 is not normal, a reset signal is outputted to the reset control unit 77 described later or an inhibit signal is transmitted to the drive inhibit signal generating circuit 78.

The internal oscillator unit 75 forms an internal clock used in the serial signal monitor unit 74 and the WD monitor unit 76 or the like. In this internal oscillator unit 75, a plurality of clock signals are generated at different time points (timings) and the serial signal monitor unit 74 and WD monitor unit 76 select the clock signal of appropriate timing as a monitor signal to realize a monitoring function.

The WD monitor unit 76 monitors whether the arithmetic operation in the microcomputer 60 is performed normally or not based on the data such as arithmetic operation period produced from the microcomputer 60. For example, since the WD monitor signal is produced as a signal that is alternately inverted when the arithmetic operation is performed normally, if the WD monitor signal is not inverted alternately, it indicates that the arithmetic operation of the microcomputer 60 is not executed normally. When the arithmetic operation of the microcomputer 60 is not executed in the normal period, a reset signal is outputted to the reset control unit 77 described later or the inhibit signal is transmitted to the drive inhibit signal generating circuit 78.

At the time of initialization or when the reset signal is inputted to the reset control unit 77 from the serial signal monitor unit 74, WD monitor unit 76 and power supply monitor unit 83 described later, the reset signal is transmitted to the microcomputer 60. Upon reception of this reset signal, the microcomputer 60 sets the values thereof to a mode of a predetermined reset condition. For example, the microcomputer 60 stops all arithmetic operations. Moreover, this reset signal is also transmitted to the serial communication buffer 73 and serial signal monitor unit 74 for the purpose of initialization based on this reset signal.

The drive inhibit signal generating unit 78 transmits a solenoid drive inhibit signal and a motor drive inhibit signal to the relay drive unit 79 based on the inhibit signals from the serial signal monitor unit 74, the WD monitor unit 76, the excessive-heating protection circuit 81 and power supply monitor unit 83 described later and also transmits directly the drive inhibit signal to a solenoid drive driver 90 without via the microcomputer 60. Therefore, when the solenoid drive inhibit signal is transmitted from the drive inhibit signal generating unit 78, the drive of solenoids is inhibited even when the microcomputer 60 is in operation.

The relay drive unit 79 controls switching of a semiconductor relay unit 100 and also controls power supply to the motor to drive the solenoids and pumps 45a, 45b based on the solenoid drive signals and motor drive signal from the microcomputer 60. Moreover, when the solenoid drive inhibit signal and motor drive inhibit signal are inputted from the drive inhibit signal generating unit 78 and the output monitor unit 92 of the solenoid driver 90, the relay drive unit 79 stops power supply to the solenoids and to the motor with the semiconductor relay unit 100.

The lamp drive unit 80 outputs under the normal condition the operating condition of the ABS control based on an ABS control condition signal from the microcomputer 60. However, it outputs a non-operating condition of the ABS control when the reset signal from the reset control unit 77 is inputted or when the solenoid drive inhibit signal and the motor drive inhibit signal are inputted from the drive inhibit signal generating unit 78. The lamp not illustrated lights up by receiving the signal from the lamp drive unit 80 to ensure the operating condition of the ABS control.

The excessive-heating protection circuit 81 detects that the chip has reached a predetermined temperature in order to prevent that the chip providing the peripheral circuit 70 reaches the predetermined temperature. When the chip has reached the predetermined temperature, the drive inhibit signal generating unit 78 is caused to generate the inhibit signal and stop supply of voltage to the microcomputer 60 in view of preventing further temperature rise.

The power supply output circuit 82 corresponds to a monitored block and is connected to a power supply terminal (first power supply terminal) 101 and a ground terminal (first ground terminal) 103 connected to an external power supply allocated at the outside of the ECU 50. The power supply output circuit 82 outputs a predetermined voltage (for example, 5V, 3.3V) based on the voltage applied to the power supply terminal 101. An output voltage of the power supply output circuit 82 is used as a power supply voltage of the microcomputer 60, the peripheral IC 70 and the solenoid driver 90 or the like. Details of this power supply circuit 82 will be described later.

The power supply monitor unit 83 corresponds to a monitor block and is connected to a power supply terminal (second power supply terminal) 105 other than the power supply terminal 101 connected with the power supply output circuit 82 and a ground terminal (second power supply terminal) 107. The power supply monitor unit 83 monitors whether the output voltage of the power supply output circuit 82 is the predetermined value or not and also monitors whether the voltage applied to the power supply output circuit 82 is an excessive voltage or not. For example, when the output voltage of the power supply output circuit 82 is less than the predetermined voltage, a reset signal is transmitted to the reset control unit 77. When it is higher than the predetermined value, an inhibit signal is transmitted to the drive inhibit signal generating unit 78. Moreover, the voltage applied to the power supply output circuit 82 is excessive voltage, the inhibit signal is outputted to the drive inhibit signal generating unit 78 and supplying of voltage to the microcomputer 60 is stopped to prevent excessive-heating. Details of this power supply monitor unit 83 will be described later.

The signal input/output buffer 84 is connected to a terminal 84a for checking for diagnosis when a car has a failure and makes communication with the microcomputer 60 by connecting a tester to the terminal 84a. Moreover, the signal input/output buffer 84 may be used as only an output buffer, for example, as a buffer which outputs the signal for indicating a vehicle speed displayed on a vehicle speed meter ( for example, a signal corresponding to the estimated vehicle speed calculated from the wheel speed).

The temperature monitor unit 85 always detects temperature of the ECU 50. The temperature monitor unit 85 outputs the signal depending on the temperature of ECU 50 to the microcomputer 60 as a temperature detection signal. Based on this temperature detection signal, the microcomputer 60 performs the arithmetic operation for the ABS control depending on the detected temperature.

The solenoid driver 90 comprises MOS transistors 91 connected to the solenoids, output monitor units 92 for monitoring voltage supply condition to the solenoids (MOS transistors 91) and AND circuits 93 for ON/OFF drive of the MOS transistors 91.

The MOS transistors 91 are connected to the respective solenoids of the various control valves 21 to 24, 31 to 34 illustrated in Fig. 1 to execute switching for voltage supply.

The output monitor units 92 are provided on one-to-one basis to the solenoids to monitor a driver output to each solenoid. For example, it monitors the voltage supplying condition to the solenoid based on the drain voltage and drain current of the MOS transistor 91. Thereby, for example, it is detected whether a drain current is excessive or not and whether a power supply wire to the solenoid is open or not or the current is leaking or not, and moreover whether the MOS transistor 91 is in the excessively high temperature or not. Thereby, if the result not suitable for driving the solenoid is attained, the output monitor unit 92 transmits the solenoid drive inhibit signal and the motor drive inhibit signal to the relay drive unit 79 and also outputs the solenoid drive inhibit signal to the AND circuit 93.

To the AND circuit 93, an output signal of the microcomputer 60, an output signal from the relay drive unit 79, an output signal from the drive inhibit signal generating unit 78 and an output signal from the output monitor unit 92 are inputted. In the case of this embodiment, the output signals from the relay drive unit 79, the drive inhibit signal generating unit 78 and the output monitor unit 92 are normally at low level. However, if any failure occurs, it turns to high level and the output of the AND circuit 93 becomes low, that is, the MOS transistor 91 turns off.

Thus, the solenoid driver 90 not only shuts off the power supply to the solenoid based on the signal from the microcomputer 60 and peripheral IC 70 but also shuts off the power supply to the solenoid based on the signal from the output monitor unit 92 provided within the solenoid driver 90 itself.

In the semiconductor relay unit 100, the power supply to the solenoids is switched by a semiconductor relay 100a, while the power supply to the motor to drive the pumps 45a, 45b is switched by a semiconductor relay 100b. These semiconductor relays 100a, 100b are constructed to be controlled on the basis of the signal from the relay drive unit 79 to normally enable power supply to the solenoids and the motors and to disable the power supply to the solenoids and the motors upon reception of the solenoid drive inhibit signal and the motor drive inhibit signal from the relay drive unit 79. These semiconductor relays 100a, 100b correspond to load drive apparatuss. The semiconductor relays 100a and 100b are constructed in the same way.

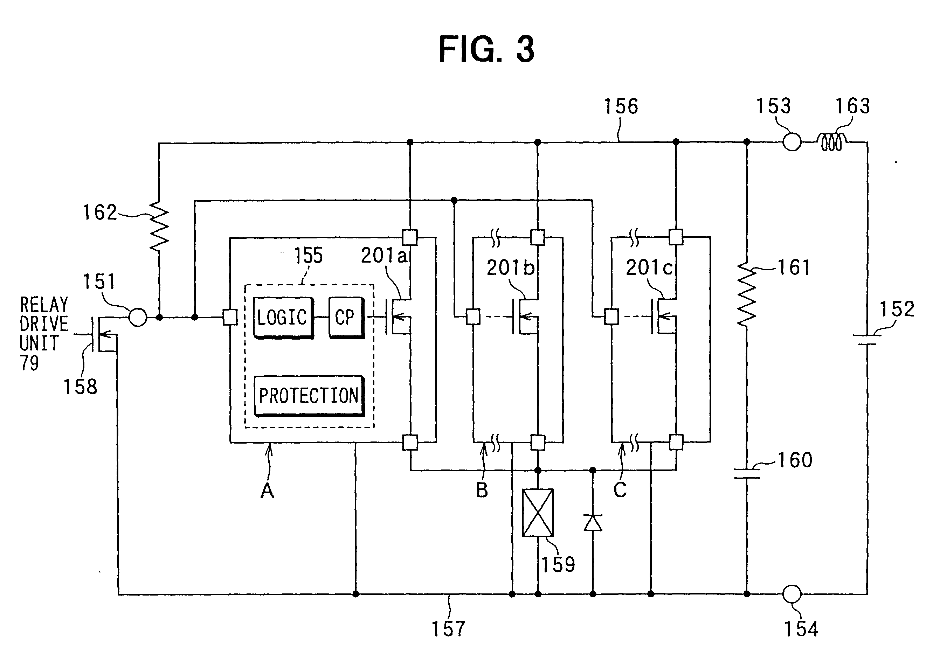

As illustrated in Fig. 3, the semiconductor relay 100b comprises power MOS transistors 201a, 201b, 201c and connects in parallel intelligent power devices (IPD) A, B, C (three units are used in this figure) for driving on and off the power MOS transistors 201a to 201c. However, in this figure, only the leftmost side IPD is described among a plurality of IPD A to C. In practice, all IPD A to C have the similar structure to that of the IPD A.

This semiconductor relay 100b has three terminals of input terminal 151 to which an input voltage is applied from the relay drive unit 79, a power source terminal 153 connected to the positive pole side of a power source 152 of a vehicle battery or the like and a ground terminal 154 connected to the negative pole side of the power source. One voltage supply line 156 and one ground line 157 are used in common as the voltage supply line and the ground line to the power MOS transistors 201a to 201c and as the voltage supply line and the ground line to a control unit 155 provided in the IPD A to C.

The input voltage is applied respectively to a plurality of IPD A to C via the MOS transistor 158 and current supply to a load 159 allocated between the source electrodes of the power MOS transistors 201a to 201c and the ground line 157 is on/off-controlled by driving in parallel a plurality of IPD A to C.

Moreover, a capacitor 160 is provided between the power source line 156 and the ground line 157 for ESD surge protection and a resistor (first resistor) 161 is also provided in series connection to the capacitor 160.

Moreover, a resistor (second resistor) 162 is provided between the power source terminal 153 and the input terminal 154. No capacitor is allocated between the input terminal 151 and the ground terminal 154. Here, an inductance 163 indicates an inductance of a wire connecting the power source 152 and power source terminal 153.

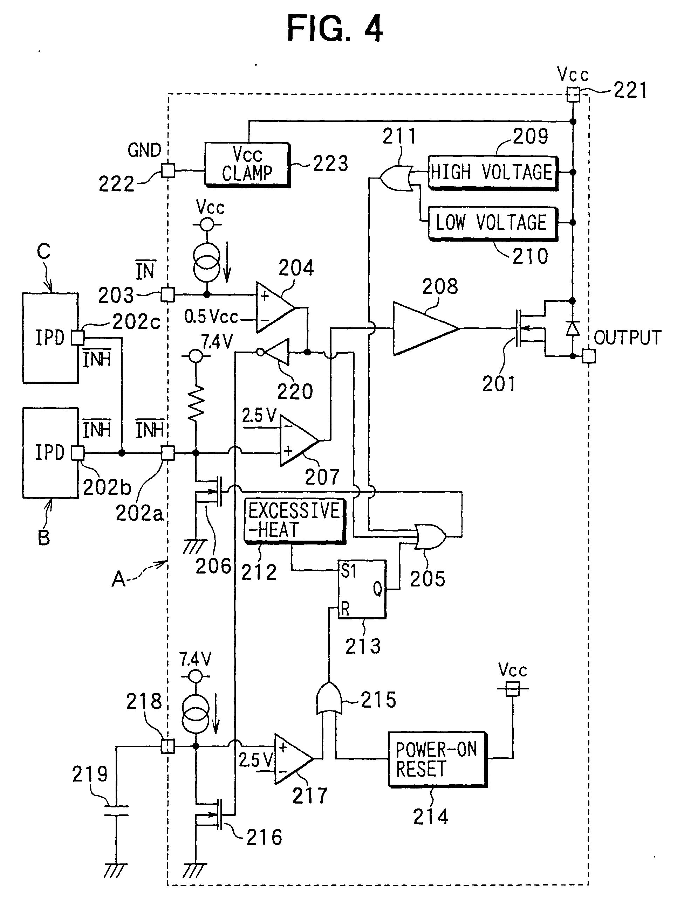

The IPD A is constructed as shown in Fig. 4. The other IPDs B and C are also constructed in the same manner. In the IPD A, a voltage based on the duty control signal of the relay drive unit 79 is applied to an input terminal (IN terminal) 203 of the IPD A. Specifically, a low level voltage is applied from the relay drive unit 79 while the motor is driven. A high level voltage is applied from the relay drive unit 79 when the motor is not driven and the motor drive inhibit signal is transmitted.

The voltage applied to the input terminal 203 is compared with a predetermined threshold value voltage Vth ( for example, $0.5 \times$ Vcc) by a comparator (first comparator) 204 and the comparison result is outputted to a MOS transistor 206 via an OR circuit 205. Therefore, when the high level voltage is applied to the input terminal 203 when the motor is not driven and when the motor drive inhibit signal is transmitted, the OR circuit 205 outputs the high level to turn on the MOS transistor 206. Thereby, the voltage of the inhibit (INH) input/output terminal 202a becomes low level. The low level output from the INH input/output terminal 202a corresponds to the inhibit signal to inhibit the power MOS transistors 201a to 201c to turn on.

When the voltage of INH input/output terminal 202a becomes low level as explained above, an output of a comparator 207 becomes low level and an output from a driver circuit 208 becomes low level to turn off the power MOS transistor 201a.

On the other hand, since the INH input/output terminal 202a of IPD A is connected to the INH input/output terminals 202b, 202c of IPD B, C when the voltage of the INH input/output terminal 202a of IPD A becomes low level, the voltage of the INH input/output terminals 202b, 202c of IPD B, C also become low level. Therefore, the IPD B, C in the same circuit structure of IPD A turn off the power MOS transistors 201b, 201c in the IPD B, C.

As explained above, when the high level voltage is applied from the relay drive unit 79, the power MOS transistor 201a to 201c in the IPD A and the other IPD B, C are turned off simultaneously.

Moreover, IPD A has a high voltage detection unit 209 and a low voltage detection unit 210. The high voltage detection unit 209 compares the voltage Vcc to drive a motor with a predetermined voltage value higher than the voltage Vcc in the normal condition in order to detect that the voltage Vcc is higher than a predetermined voltage value. In this embodiment, when the voltage Vcc is higher than the predetermined voltage value, the high level is outputted. Moreover, the low voltage detection unit 210 compares the voltage Vcc to drive a motor with a predetermined voltage value which is lower than the voltage Vcc in the normal condition to detect that the voltage Vcc is lower than the predetermined voltage value. In this embodiment, the high level is output when the voltage Vcc is lower than the predetermined voltage value.

When these high voltage detection unit 209 or low voltage detection unit 210 output the high level, the OR circuit 205 outputs the high level via an OR circuit 211 to turn on the MOS transistor 206. Thereby, the voltage of the INH input/output terminal 202a becomes the low level.

When the voltage of the INH input/output terminal 202a becomes low level, an output of the comparator 207 becomes low level, thereby an output of the driver circuit 208 becomes low level and the power MOS transistor 201a turns off. Therefore, as explained above, the voltage of the INH input/output terminals 202b, 202c of the IPD B, C becomes low level as explained above and thereby the power MOS transistors 201b, 201c of the other IPD B, C turn off.

As explained above, even when the motor drive voltage is detected higher or lower than a predetermined voltage with the high voltage detection unit 209 and the low voltage detection unit 210 in the IPD A , the power MOS transistors 201a to 201c in the IPD A and the IPD B, C are simultaneously turned off.

Here, the high voltage detection unit 209 and low voltage detection unit 210 are also provided in IPD B, C as in the case of IPD A. However, even when it is detected by the high voltage detection unit 209 and the low voltage detection unit 210 provided in the IPD B that the motor drive voltage is higher or lower than the predetermined voltage value, the INH input/output terminals of IPD B, C become low level and the power MOS transistors 201a to 201c provided in the IPD A to C are simultaneously turned off.

Moreover, the IPD A has an excessive-heat detection unit 212. This excessive-heat detection unit 212 detects that the chip is in the excessive-heat condition at the temperature higher than a predetermined temperature in order to prevent that the chip in which the IPD A is comprised is in the abnormally higher temperature. In this embodiment, the excessive-heat detection unit 212 outputs a high level signal when the chip is in the excessively high temperature.

When the high level signal is inputted to a RS flip-flop 213 from the excessive-heat detection unit 212, an output of the RS flip-flop 213 is set to the high level and thereby the OR circuit 205 outputs high level.

Therefore, like the case where the high voltage is detected as explained above, the voltage of INH input/output terminal 202a becomes low level and the power MOS transistors 201a to 201c provided in the IPD A to C are simultaneously turned off.

On the other hand, when the motor is driven or when various abnormal conditions are canceled, the output of the OR circuit 205 becomes low level to try to turn on the power MOS transistors 301a to 201c provided in the IPDs A to C.

In this case, since the INH input/output terminals 202a to 202c of each IPD A to C are connected with each other, the INH input/output terminals 202a to 202c of each IPD A to C do not become high level, if not only the MOS transistor 206 provided in the IPD A but also the MOS transistor of the same structure as the MOS transistor 206 provided in the IPD A among the IPD B, C are not turned off.

Therefore, the power MOS transistors 201b, 201c provided in each IPD B, C are also turned on simultaneously.

A power source terminal 221 to which the power source voltage Vcc is applied and the ground terminal 222 indicated as GND are connected with each other via a Vcc clamp circuit 223 in order to protect IPD A even when the ESD surge is generated or at the time of load dumping.

Moreover, in this embodiment, the RS flip-flop 213 is reset based on the initial condition setting signal from the power-on reset unit 214 and the signal from the input terminal 203.

That is, when the OR circuit 215 outputs the high level with the initial condition setting signal (high level signal) from the power-on reset unit 214, and when the MOS transistor 216 is turned on and OFF with the duty drive signal from the relay drive unit 79 and the drain voltage of the MOS transistor 216 is higher than a predetermined voltage (here, 2.5V) and the comparator 217 outputs the high level, the RS flip-flop 213 is reset.

Next, features of the semiconductor relay 100b having the structure explained above will be explained.

(1) In the semiconductor relay 100b of this embodiment, a resistor 161 is connected in series to the capacitor 160 to protect the ESD surge or the like as explained above. Since such resistor is provided, the LC oscillation with the inductance element of the wire connecting the power source 152 and power source terminal 153 and the capacitor 160 can be suppressed.

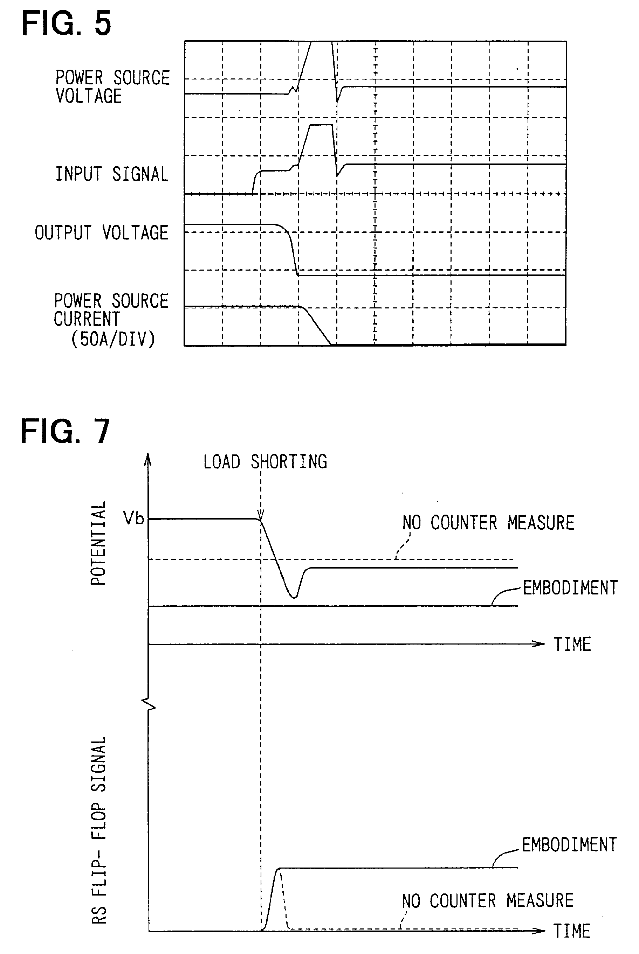

Fig. 5 illustrates output waveforms at each portion of the semiconductor relay 100b when the voltage supply stops in such a case that a resistor is provided as explained above. As illustrated in this figure, since the resistor 161 is provided, it can absorb the influence of inductance element of wire connecting the power source 152 and semiconductor relay 100b as the load drive apparatus.

Thereby, the voltage of the power source supply line can be stabilized and drop of the power source supply line can be prevented momentarily.

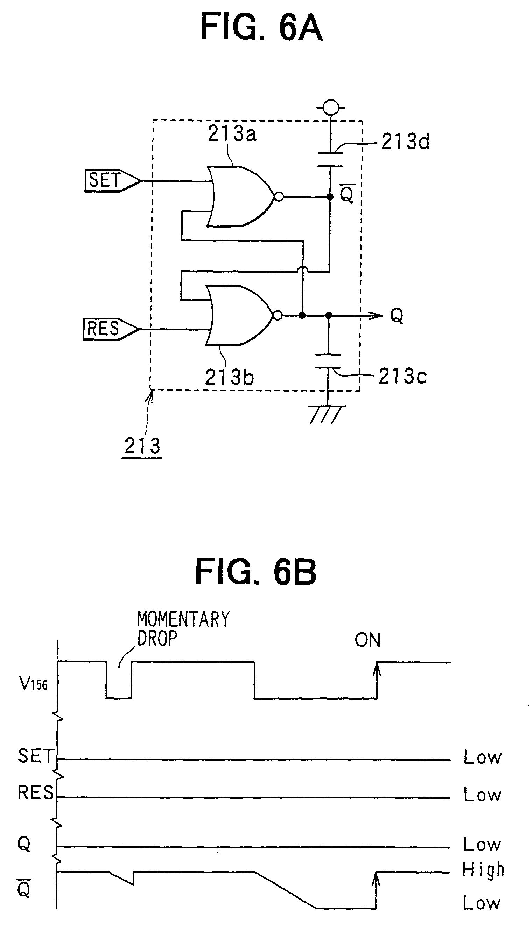

In addition, in the case of this embodiment, the output of the RS flip-flop (latch) 213 is latched so that the power MOS transistor 201 is turned off when excessive-heat condition is detected. The logical structure of this RS flip-flop 213 is illustrated in Fig. 6A.

As illustrated in this figure, the RS flip-flop 213 has a structure provided with a couple of NOR circuits 213a, 213b. The one NOR circuit (first NOR circuit) 213a is comprised to input the signal connected to the set terminal SET(S) and an output signal of the other NOR circuit (second NOR circuit) 213b. The other NOR circuit 213b is comprised to input the signal connected to the reset terminal RES(R) and an output signal of the other NOR circuit 213a. Among those, an output of the NOR circuit 213b becomes an output of the RS flip-flop 213, while an output of the NOR circuit 213a becomes an inverted output of the RS flip-flop 213.

Moreover, a capacitor (the fourth capacitor) 213c is connected between the NOR circuit 213b and the ground potential and a capacitor (the third capacitor) 213d is also connected between the NOR circuit 213a and the power source.

Operation of the RS flip-flop 213 comprised as explained above is illustrated in Fig. 6B.

As illustrated in this figure, since an output voltage of the NOR circuit 213a is held with the capacitor 213d, if the voltage V156 of voltage supply line 156 varies or drops momentarily, condition of the RS flip-flop 213 is held with the capacitors 213c, 213d and thereby the RS flop-flop 213 does not operate erroneously.

As explained above, the power MOS transistors 201a to 201c are protected from erroneous turning on by maintaining an output of the RS flip-flop 213 during a predetermined period.

When the power source voltage rises, since the alternating current components at the rise time of voltage passes through the capacitor connected to an output of the NOR circuit 213b, the RS flip-flop 213 is initially set to the reset condition.

(2) Moreover, in this embodiment, the power-on reset unit 214 adjusts the threshold level to generate the initial condition set signal (power-on reset signal) and sets it to the threshold level which is lower than the voltage of the voltage supply line assumed when a shorting is generated in the load.

That is, when the power source voltage is vb, the internal resistance of power source 152 is Rb, resistance of wire connecting the power source 152 and power source terminal 153 is Rw, on-resistance of power MOS transistors 201a to 201c is Ron, shorting resistance at the motor is Rs, the threshold level with which the power-on reset unit generates the initial condition set signal satisfies the following relationship.

[Formula 1]

$$\text{Threshold level} \leq \frac{\text{Ron} + \text{Rs}}{\text{Ron} + \text{Rs} + \text{Rw} + \text{Rb}} \times \text{Vb}$$

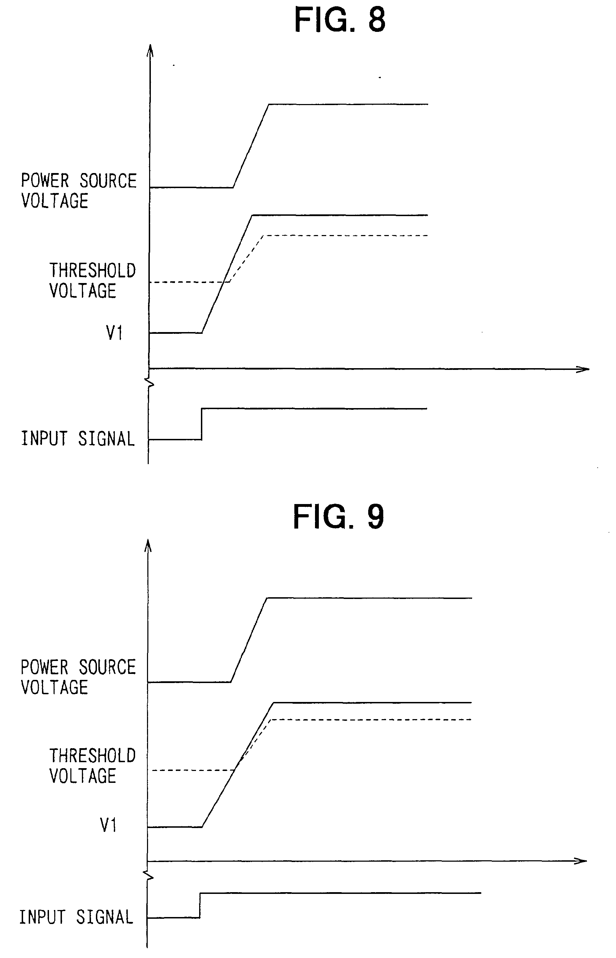

Fig. 7 illustrates the relationship between the voltage of the voltage supply line 156 and threshold level in the case where the threshold level is set to the value lower than the voltage of the voltage supply line 156 assuming the shorting of load and in the case where the threshold level is set to the value higher than the voltage produced when no countermeasure is taken. Moreover, Fig. 7 illustrates the output signal waveforms of the RS flip-flop 213 in the case of this embodiment and in the case of no countermeasure.

As will be understood from these figures, when the threshold level is set to the value higher than the voltage of the voltage supply line 156 assumed for shorting of load when no countermeasure is taken, a latch output of the RS flip-flop 213 is canceled and the power MOS transistors 201a to 201c are turned on even in such a condition that the power MOS transistors 201a to 201c must be turned off.

On the other hand, as in the case of this embodiment, when the threshold level is set to the value lower than the voltage of the voltage supply line 156 assumed for shorting of load, the latch output of the RS flip-flop 213 is not canceled and thereby the power MOS transistors 201a to 201c can be maintained in the OFF condition.

Thereby, breakdown of the power MOS transistors 201a to 201c due to the malfunction of the RS flop-flop 213 can be prevented to realize protection of the semiconductor relay 100b.

(3) Moreover, in this embodiment, the structure does not include a capacitor between the resistor 162 (Fig. 3). Therefore, an input signal to turn off the power MOS transistors 201a to 201c is inputted from the relay drive unit 79, each portion of the IPD A shows the voltage waveforms of Fig. 8.

As illustrated in this figure, when the input voltage V1 rises exceeding the threshold value voltage, the comparator 204 outputs the high level. In this case, since no capacitor is provided between the input terminal 152 and the ground line 157, delay of rise of the input voltage V1 due to the influence of capacitor is canceled. Even if the threshold value voltage rises suddenly due to the flyback voltage, it is no longer observed that the threshold value voltage exceeds the input voltage V1 to turn on the power MOS transistors 201a to 201c.

As explained above, delay of rise of the input voltage V1 due to the influence of capacitor can be presented by eliminating the capacitor, and thereby an output of the comparator 204 is inverted when the flyback voltage is generated and it can be prevented that the power MOS transistors 201a to 201c are turned on.

Thereby, it can also be prevented that stress is repeatedly applied to the power MOS transistors 201a to 201c and the load drive apparatus can be protected sufficiently.

(Second Embodiment)

In a second embodiment, it is assumed that a capacitor (not shown) is connected between the input terminal 152 and the ground line 157. This may cause a delay of rise of the input voltage V1 as shown in Fig. 9 against the first embodiment (Fig. 8). This delay can be eliminated by adjusting the time constant of such a capacitor and the resistor 162. Fig. 9 illustrates the voltage waveforms at each portion of IPD A, when an input signal to turn on the power MOS transistors 201a to 201c is inputted from the relay drive unit 79.

As illustrated in this figure, rise of input voltage V1 is slightly delayed in comparison with the first embodiment. The similar advantage to that of the first embodiment can also be attained by setting the time constant to make higher the input voltage V1 than the rise amount of the threshold value voltage when the flyback voltage is generated.

Thereby, it can be prevented that stress is repeatedly applied to the powr MOS transistors 201a to 201c with delay of rise of the input voltage.

(Third Embodiment)

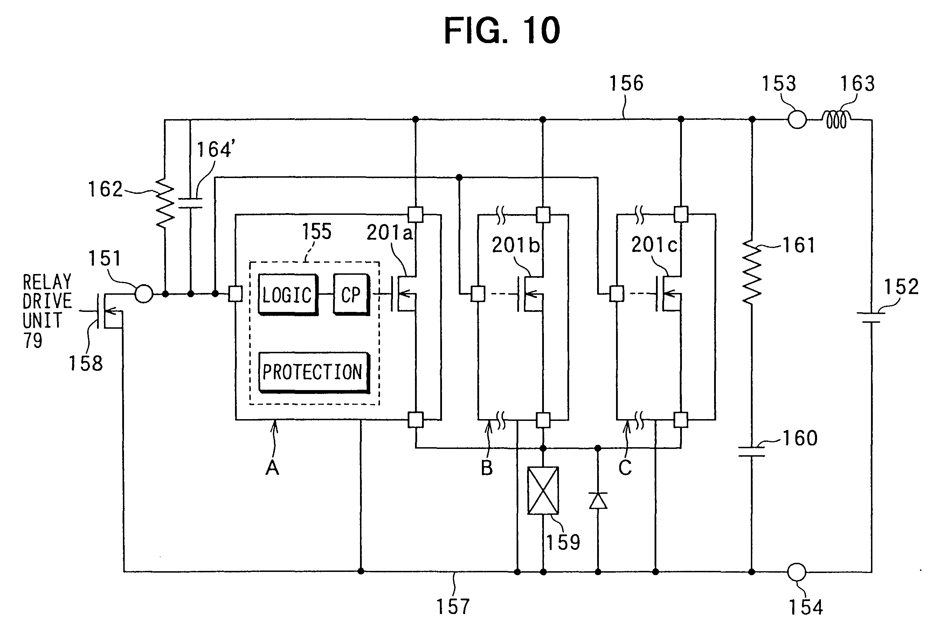

The circuit structure of the semiconductor relay 100b of this embodiment is illustrated in Fig. 10. In this embodiment, a capacitor 164' is connected between the power source supply line 156 and the input terminals 151 of IPD A to C to constitute the parallel connection of the capacitor 164' for the resistor 162. Charging of the capacitor 164' can be stopped by this arrangement and thereby delay of rise of the input voltage V1 can be prevented.

In this case, when an input signal to turn off the power MOS transistors 201a to 201c is inputted from the relay drive unit 79, the voltage waveforms at each portion of IPD A becomes almost identical to that of Fig. 8.

Thereby, it can be prevented that stress is repeatedly applied to the power MOS transistors 201a to 201c with delay of rise of the input voltage V1.

(Fourth Embodiment)

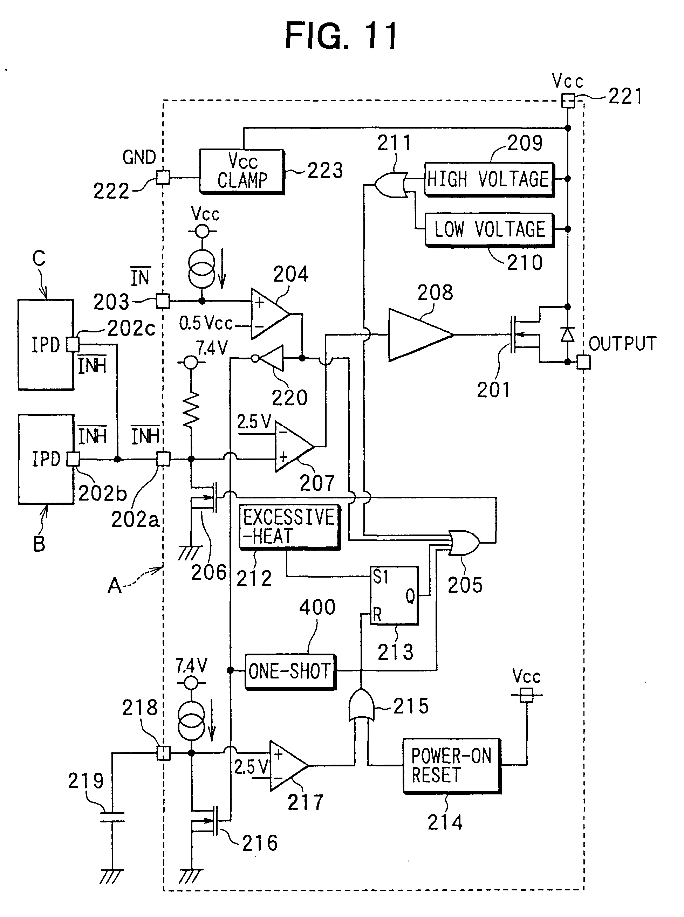

In this embodiment, a problem in delay of rise of the input voltage V1 can be solved by modifying the structures of the IPD A to C. Fig. 11 shows a circuit structure of IPD A in this embodiment.

As illustrated in Fig. 11, in this embodiment, an output of the comparator 204 is inputted to a one-shot multivibrator 400 via the inverter circuit 220 and thereby an output of the one-shot multivibrator 400 is inputted to the OR circuit 205.

With employment of such a structure, when the output of the comparator 204 becomes high level once and the low level is inputted to the one-shot multivibrator 400, the power MOS transistors 201a to 201c are turned off during a predetermined period.

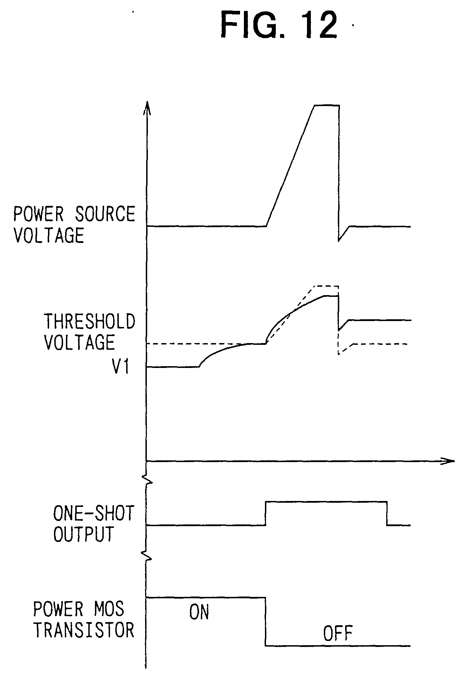

Fig. 12 illustrates voltage waveforms at each portion of IPD A in this embodiment. As illustrated in this figure, even when the delay of rise of the input voltage V1 is generated and the threshold value voltage exceeds the input voltage V1, the one-shot multivibrator 400 outputs the high level signal during the predetermined period. Therefore, the power MOS transistors 201a to 201c can be turned off during this period without erroneous turning on.

Thereby, it can be prevented that stress is repeatedly applied to the power MOS transistors 201a to 201c with delay of rise of the input voltage V1.

(Fifth Embodiment)

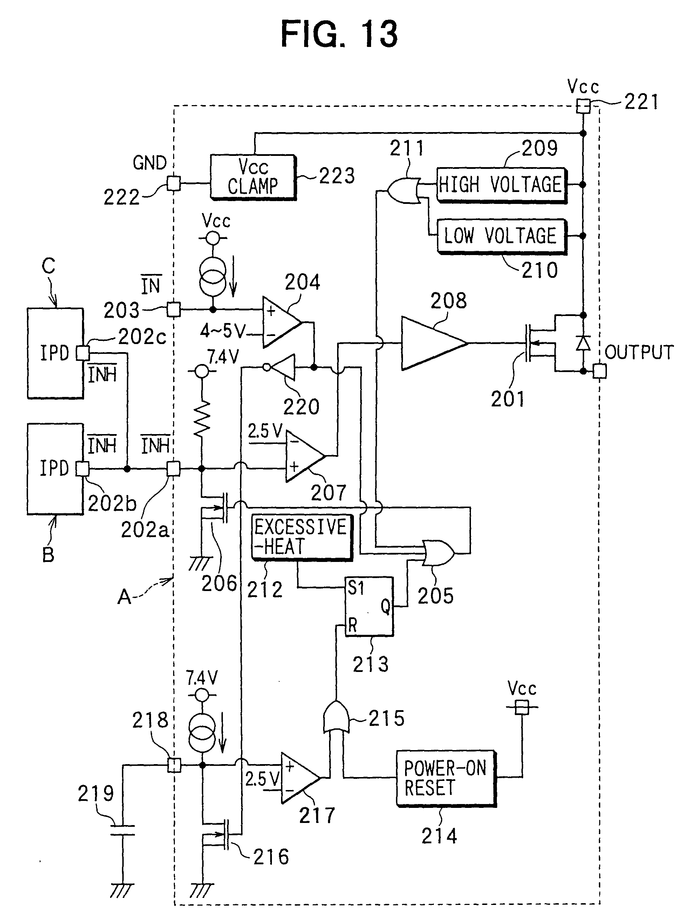

This embodiment also solves the problem resulting from delay of rise of the input voltage V1 by modifying the structures of IPD A to C. Fig. 13 shows a circuit structure of IPD A in this embodiment.

As illustrated in Fig. 13, in this embodiment, the threshold value voltage of the comparator 204 is fixed, for example, to 4 to 5V so that it is no longer varied with variation of the power source voltage. This threshold value voltage can be fixed, for example, with a Zener diode or an internal power source circuit.

When the threshold value voltage of the comparator 204 is fixed as explained above, even if the rise of input voltage is delayed due to the influence of a capacitor between the input terminal 152 and the ground line 157, it is prevented that the threshold value voltage rises suddenly with the flyback voltage exceeding the input voltage.

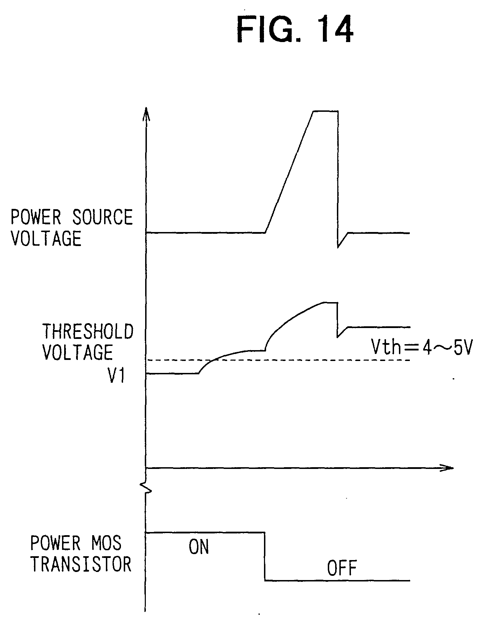

Fig. 14 illustrates the voltage waveforms at each portion of IPD A in this embodiment. As illustrated in this figure, the threshold value voltage does not exceed the input voltage V1 even if delay of rise of the input voltage V1 is generated because the threshold value voltage is fixed.

Thereby, it can be prevented that stress is repeatedly applied to the power MOS transistors 201a to 201c due to the delay of rise of the input voltage V1.

(Sixth Embodiment)

This embodiment solves the problem in delay of rise of the input voltage V1 by modifying the threshold level in the high voltage detection unit 209 of IPD A. This embodiment changes only a threshold level Vhigh of the high voltage detection unit 209 in Fig. 4. Therefore, explanation will be made with reference to Fig. 4.

In this embodiment, the threshold level which is detected by the high voltage detection unit 209 when it becomes high voltage is set to a low voltage. The high voltage detection unit 209 has a comparator (not illustrated) and outputs the high level to the OR circuit 211 by detecting a high voltage when the power source voltage becomes higher than the threshold level to turn off the power MOS transistors 201a to 201c.

When the flyback voltage is generated, the high voltage detection unit 209 turns off the power MOS transistors 201a to 201c by setting the threshold level of the high voltage detection unit 209 to the voltage lower than the flyback voltage.

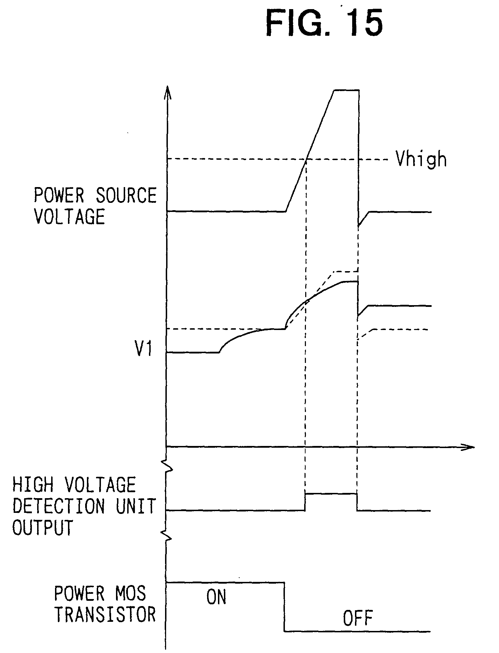

Fig. 15 illustrates voltage waveforms of each portion of IPD A in this embodiment. As illustrated in Fig. 15, even if rise voltage of input voltage V1 is delayed, the power source voltage rapidly rises exceeding the threshold level of the high voltage detection unit 410. Therefore, the high voltage detection unit 410 outputs the high level before the threshold value voltage exceeds the input voltage V1. Thereby, when the flyback voltage is generated, the power MOS transistors 201a to 201c can be turned off and thereby it can be prevented that stress is repeatedly applied to the power MOS transistors due to the delay of rise of the input voltage V1.

(Other Embodiment)

In each embodiment explained above, the load drive apparatus explained includes three IPD A to C comprising the power MOS transistor as the semiconductor switching device, but each embodiment can also be applied to various cases where only one IPD is used or a plurality of IPDs are used.

The present invention should not be limited to the above disclosed embodiments, but may be implemented in many other ways without departing from the spirit of the invention.

**Claims**

1. A load drive apparatus for switching a current supplied from a power source (152) to a load (159) by driving switching means (A, B, C), which has a switching device (201a, 201b, 201c) and a control unit (155) for controlling a switching operation of the switching device, **characterized by** comprising:

   a power source terminal (153) connected to a power source side of the power source (152);
   a ground terminal (154) connected to a ground side of the power source (152);
   a voltage supply line (156) connected to the power source terminal to supply a voltage to the switching device and the control unit; and
   a ground line (157) connecting the switching device and the control unit to the ground terminal.

2. The load drive apparatus as in claim 1, further **characterized in that**:

   the voltage supply line (156) connected to the power source terminal is used in common to both of the control unit and the switching device; and
   the ground line (157) connected to the ground terminal is used in common to both of the control unit and the switching device.

3. The load drive apparatus as in claim 1, further **characterized in that**:

   the switching means (A, B, C) includes a plurality of parallel-connected switching circuits (A, B, C), each of which has the switching device (201a, 201b, 201c) and the control unit (155), to drive in parallel the plurality of switching circuits;

the voltage supply line (156) is connected in common to the control unit and the switching device of each of the switching circuits; and

the ground line (157) is connected in common to the control unit and the switching device of each of the switching circuits.

4. The load drive apparatus as in claim 1, further **characterized in that**:

the switching means (A, B, C) includes a plurality of parallel-connected switching circuits (A, B, C), each of which has the switching device (201a, 201b, 201c) and the control unit (155), to drive in parallel the plurality of switching circuits;

the voltage supply line (156) is connected to the power source terminal to supply the voltage to the control unit and the switching device of each of the switching circuits; and

the ground line (157) is connected to the ground terminal, and the control unit and the switching device of each of the switching circuits.

5. The load drive apparatus as in any one of claims 1 to 4, further **characterized by** comprising:

a first capacitor (160) connected between the power source terminal and the ground terminal; and

a first resistor (161) connected in series with the first capacitor.

6. The load drive apparatus as in claim any one of claims 1 to 5, further **characterized by** comprising:

an input terminal (151) provided so that an input signal is inputted from an external side and the switching means controls ON and OFF conditions of the switching device based on the input signal applied to the input terminal.

7. The load drive apparatus as in claim 6, further **characterized in that**:

the control unit (155) has a first comparator (204) to compare the input signal applied to the input terminal and a predetermined voltage preset with the voltage of the power source; and

the first comparator (204) outputs a control signal to turn off the switching device when the input signal applied to the input terminal is higher than the predetermined voltage.

8. The load drive apparatus as in claim 7, further **characterized by** comprising:

a second resistor (162) connected between the input terminal (151) and the power source terminal (153).

9. The load drive apparatus as in claim 8, further **characterized by** comprising:

a second capacitor (164) connected between the input terminal and the ground terminal, wherein a time constant of the second resistor and the capacitor is set so that the input signal applied to the input terminal rises faster than a predetermined voltage which is caused to rise with a flyback voltage applied to the voltage supply line when the switching device is turned off.

10. The load drive apparatus as in claim 8, further **characterized by** comprising:

a second capacitor (164') connected between the input terminal and the power source terminal.

11. The load drive apparatus as in claim 7, further **characterized by** comprising:

a one-shot multivibrator (400) for maintaining an OFF condition of the switching device for a predetermined period when a control signal is outputted from the first comparator to turn off the switching device.

12. The load drive apparatus as in claim 7, further **characterized in that**:

the control unit (155) has a second comparator for comparing the voltage of the power source and a threshold voltage which is set to be lower than a flyback voltage applied to the voltage supply line when the switching device is turned off.

13. The load drive apparatus as in claim 7, **characterized in that**:

the first comparator (204) compares the input signal applied to the input terminal with a fixed voltage which does not change even with voltage change of the power source; and

the second comparator outputs the control signal to turn off the switching device when the input signal applied to the input terminal is higher than the fixed voltage.

14. The load drive apparatus as in any one of claims 1 to 13, further **characterized in that**:

the control unit (155) includes an excessive-heat detection unit (212) for detecting an excessive-heat condition of a chip on which the control unit is provided, and a latch (213) for outputting a control signal to turn off the switching device when the excessive-heat detection unit detects the excessive-heat condition, whereby the latch maintains the control signal during a predetermined period.

15. The load drive apparatus as in claim 14, furtehr **characterized in that**:

    the latch (213) is comprised as a RS flip-flop provided with a set terminal, a reset terminal, a first NOR circuit (213a) and a second NOR circuit (213b);

    both input signal from the set terminal and an output signal from the second NOR circuit are inputted to the first NOR circuit (213a), while both input signal from the reset terminal and an output signal from the first NOR circuit are inputted to the second NOR circuit (213b); and the RS flip-flop includes a third capacitor (213d) allocated between the output part of the first NOR circuit and the power source supply line, and a fourth capacitor (213c) allocated between the output part of the second NOR circuit and the ground line.

16. The load drive apparatus as in claim 14 or 15, **characterized in that**:

    the latch (213) is reset by a reset signal from a power-on reset unit (214); and the power-on reset unit outputs the reset signal when the voltage of the voltage supply line becomes lower than the voltage when a load is shorted.

FIG. 1

# FIG. 2

# FIG. 3

EP 1 152 531 A2

# FIG. 4

# FIG. 5

| POWER SOURCE VOLTAGE | |
| INPUT SIGNAL | |
| OUTPUT VOLTAGE | |
| POWER SOURCE CURRENT (50A/DIV) | |

# FIG. 7

LOAD SHORTING

POTENTIAL

Vb

NO COUNTER MEASURE

EMBODIMENT

TIME

RS FLIP- FLOP SIGNAL

EMBODIMENT

NO COUNTER MEASURE

TIME

# FIG. 6A

213a

213d

SET

$\overline{Q}$

RES

213b

213c

213

# FIG. 6B

MOMENTARY
DROP

ON

$V_{156}$

SET — Low

RES — Low

Q — Low

$\overline{Q}$ — High

Low

# FIG. 8

POWER SOURCE
VOLTAGE

THRESHOLD
VOLTAGE

V1

INPUT SIGNAL

# FIG. 9

POWER SOURCE
VOLTAGE

THRESHOLD
VOLTAGE

V1

INPUT SIGNAL

FIG. 10

# FIG. 11

# FIG. 12

POWER SOURCE
VOLTAGE

THRESHOLD
VOLTAGE
V1

ONE-SHOT
OUTPUT

POWER MOS
TRANSISTOR

ON

OFF

# FIG. 13

# FIG. 14

POWER SOURCE
VOLTAGE

THRESHOLD
VOLTAGE
V1

$Vth = 4 \sim 5V$

POWER MOS
TRANSISTOR

ON

OFF

# FIG. 15

POWER SOURCE
VOLTAGE

Vhigh

V1

HIGH VOLTAGE
DETECTION UNIT
OUTPUT

POWER MOS
TRANSISTOR

ON

OFF